(19) Europäisches Patentamt
European Patent Office
Office européen des brevets

(11) **EP 3 340 428 B1**

(12) **FASCICULE DE BREVET EUROPEEN**

(45) Date de publication et mention de la délivrance du brevet:
**09.09.2026 Bulletin 2026/37**

(21) Numéro de dépôt: **17207861.0**

(22) Date de dépôt: **15.12.2017**

(51) Classification Internationale des Brevets (IPC):
***H02J 7/35*** *(2006.01)* ***H01M 10/44*** *(2006.01)*
***H02J 7/00*** *(2026.01)*

(52) Classification Coopérative des Brevets (CPC):
**H02J 7/35; H01M 10/443; H02J 7/80; H02J 7/82; H02J 7/84; H02J 7/90; H02J 7/977;** H02J 7/875; Y02E 60/10

(54) **PROCÉDÉ ET DISPOSITIF DE CHARGE D'UNE BATTERIE**

VERFAHREN UND VORRICHTUNG ZUM AUFLADEN EINER BATTERIE

METHOD AND DEVICE FOR CHARGING A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2016 FR 1662966**

(43) Date de publication de la demande:
**27.06.2018 Bulletin 2018/26**

(73) Titulaires:
- **Commissariat à l'Energie Atomique et aux Energies Alternatives**
  **75015 Paris (FR)**
- **BUBENDORFF Société Anonyme**
  **68220 Attenschwiller (FR)**

(72) Inventeurs:
- **ZARA, Henri**
  **73370 LE BOURGET DU LAC (FR)**
- **FRITSCH, Thomas**
  **67800 HOENHEIM (FR)**
- **VIAL, Franck**
  **38850 PALADRU (FR)**
- **AL SHAKARCHI, Franck**
  **73160 SAINT-SULPICE (FR)**

(74) Mandataire: **Cabinet Beaumont**
**4, Place Robert Schuman**
**B.P. 1529**
**38025 Grenoble Cedex 1 (FR)**

(56) Documents cités:
**EP-A1- 1 883 143**
**EP-A1- 3 190 681**
**CN-A- 103 904 379**
**FR-A1- 2 964 265**
**FR-A1- 3 013 151**
**FR-A1- 3 015 124**
**JP-A- 2012 075 282**
**US-A1- 2013 049 702**
**US-A1- 2016 013 521**
**US-A1- 2016 332 531**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

### Domaine

La présente demande concerne un procédé de charge d'une batterie d'accumulateurs électriques d'un système autonome ou d'un système relié au secteur.

### Exposé de l'art antérieur

Un système autonome comprend un système électrique ou électromécanique, une batterie d'accumulateurs pour l'alimentation électrique du système électrique ou électromécanique et un générateur électrique pour la charge de la batterie. Un exemple de système autonome correspond à un volet roulant électrique alimenté par une batterie dont la charge est réalisée par des cellules photovoltaïques.

Il est généralement souhaitable que l'autonomie de fonctionnement du système autonome soit la plus longue possible. Dans ce but, on pourrait considérer qu'il est avantageux de charger la batterie au maximum dès que le générateur peut fournir de l'énergie électrique, afin d'assurer une autonomie maximale dans le cas où le générateur fournit peu d'énergie électrique pendant une longue période. Toutefois, il peut être préférable de limiter l'état de charge maximale de la batterie lorsque la température de la batterie est trop élevée. En effet, la combinaison d'un état de charge élevé et d'une température élevée accélère le vieillissement de la batterie, que ce soit au repos ou en fonctionnement.

Pour certaines applications, la batterie d'un système autonome peut être placée dans un espace non climatisé. En particulier, lorsque la batterie est disposée en extérieur, la température de la batterie peut varier fortement au cours de l'année. A titre d'exemple, pendant la période estivale, la température de la batterie peut s'élever fortement de façon temporaire au cours de la journée.

Il est connu de modifier l'état de charge maximale de la batterie en fonction de la température ambiante, voire de déconnecter la batterie du générateur. Toutefois, ce type de régulation est une régulation par réaction et non une régulation par anticipation. Il peut ne pas empêcher dans certains cas une dégradation de la batterie. En effet, lorsque l'état de charge de la batterie est déjà élevé et que la température ambiante augmente, une commande de réduction de l'état de charge maximale de la batterie reste sans effet, de sorte que la batterie va fonctionner à température élevée et avec un état de charge élevé, et la durée de vie de la batterie peut diminuer. Les documents FR 2 964 265, EP 1 883 143, FR 3 013 151, FR 3 015 124, JP 2012 075282, CN 103 904 379, US 2016/013521, US 2013/049702, US 2016/332531, et EP 3 190 681 décrivent des procédés de charge d'une batterie d'accumulateurs électriques.

### Résumé

Un objet d'un mode de réalisation est de pallier tout ou partie des inconvénients des systèmes autonomes ou des systèmes reliés au secteur décrits précédemment.

Un autre objet d'un mode de réalisation est d'augmenter la durée de vie de la batterie.

Un autre objet d'un mode de réalisation est d'augmenter l'autonomie de fonctionnement du système autonome.

Un autre objet d'un mode de réalisation est que la charge de la batterie s'adapte automatiquement aux conditions environnementales.

Ainsi, un mode de réalisation prévoit un procédé de charge d'une batterie d'accumulateurs électriques à partir de l'énergie électrique fournie par un générateur électrique, dans lequel la batterie est chargée à un premier état de charge maximale dans un premier mode de fonctionnement et à un deuxième état de charge maximale, strictement inférieur au premier état de charge maximale, dans un deuxième mode de fonctionnement, le procédé comprenant le passage du deuxième mode de fonctionnement au premier mode de fonctionnement lorsque le rapport entre une première donnée représentative de l'énergie disponible pouvant être fournie par le générateur électrique et une deuxième donnée représentative de l'énergie consommée depuis la batterie devient inférieur à un premier seuil.

Selon un mode de réalisation, le procédé comprend le passage du premier mode de fonctionnement au deuxième mode de fonctionnement lorsque le rapport entre la première donnée représentative de l'énergie disponible pouvant être fournie par le générateur électrique et la deuxième donnée représentative de l'énergie consommée depuis la batterie devient supérieur au premier seuil ou à un deuxième seuil différent du premier seuil.

Selon un mode de réalisation, la batterie est chargée à un troisième état de charge maximale strictement inférieur au deuxième état de charge maximale dans un troisième mode de fonctionnement, le procédé comprenant le passage du troisième mode de fonctionnement au deuxième mode de fonctionnement lorsque le rapport entre la première donnée et la deuxième donnée devient inférieur à un troisième seuil supérieur strictement au premier seuil.

Selon un mode de réalisation, le procédé comprend le passage du deuxième mode de fonctionnement au troisième mode de fonctionnement lorsque le rapport entre la première donnée et la deuxième donnée devient supérieur au troisième seuil, ou à un quatrième seuil différent du troisième seuil et supérieur strictement au premier seuil.

Selon un mode de réalisation, le premier état de charge maximale varie de 95 % à 100 %, le deuxième état de charge maximale varie de 50 % à 95 %, et le troisième état de charge maximale varie de 20 % à 50 %.

Selon un mode de réalisation, le premier seuil varie de 1 à 3 et le troisième seuil varie de 3 à 15.

Selon un mode de réalisation, le générateur électrique comprend des cellules photovoltaïques.

Selon un mode de réalisation, la première donnée est déterminée à partir de la mesure de l'irradiance globale reçue par les cellules photovoltaïques.

Selon un mode de réalisation, le procédé comprend la détermination de premières valeurs sur une fenêtre temporelle, la détermination de la première donnée comprenant la détermination de la moyenne des premières valeurs sur la fenêtre temporelle, le procédé comprenant, en outre, la détermination de deuxièmes valeurs, la détermination de la deuxième donnée comprenant la détermination de la moyenne des deuxièmes valeurs sur la fenêtre temporelle.

Selon un mode de réalisation, la durée de la fenêtre temporelle dans le premier mode de fonctionnement est différente de la durée de la fenêtre temporelle dans le deuxième mode de fonctionnement.

Selon un mode de réalisation, la durée de la fenêtre temporelle est modifiée au bout d'une période de fonctionnement de la batterie.

Selon un mode de réalisation, le procédé comprend en outre la détermination de l'état de santé de la batterie et le maintien de l'état de charge de la batterie au premier état de charge maximale lorsque l'état de santé diminue en dessous d'une valeur d'état de santé.

Selon un mode de réalisation, la charge de la batterie est, en outre, interdite tant que la température de la batterie est supérieure à une cinquième valeur de température.

Selon un mode de réalisation, la charge de la batterie est, en outre, interdite tant que la température de la batterie est inférieure à une sixième valeur de température.

Un mode de réalisation prévoit également un système comprenant un générateur électrique, une batterie, un circuit de charge de la batterie à partir de l'énergie électrique fournie par le générateur, et un module de commande du circuit de charge, le module de commande étant adapté à commander la charge de la batterie à un premier état de charge maximale dans un premier mode de fonctionnement et à un deuxième état de charge maximale, strictement inférieur au premier état de charge maximale, dans un deuxième mode de fonctionnement, le module de commande étant adapté à passer du deuxième mode de fonctionnement au premier mode de fonctionnement lorsque le rapport entre une première donnée représentative de l'énergie disponible pouvant être fournie par le générateur électrique et une deuxième donnée représentative de l'énergie consommée depuis la batterie devient inférieur à un premier seuil.

Selon un mode de réalisation, le module de commande est adapté à passer du premier mode de fonctionnement au deuxième mode de fonctionnement lorsque le rapport entre la première donnée représentative de l'énergie disponible pouvant être fournie par le générateur électrique et la deuxième donnée représentative de l'énergie consommée depuis la batterie devient supérieur au premier seuil ou à un deuxième seuil différent du premier seuil.

Selon un mode de réalisation, le module de commande est adapté à commander la charge de la batterie à un troisième état de charge maximale strictement inférieur au deuxième état de charge maximale dans un troisième mode de fonctionnement, et le module de commande est adapté à passer du troisième mode de fonctionnement au deuxième mode de fonctionnement lorsque le rapport entre la première donnée et la deuxième donnée devient inférieur à un deuxième seuil supérieur strictement au premier seuil.

Selon un mode de réalisation, le module de commande est adapté à passer du deuxième mode de fonctionnement au troisième mode de fonctionnement lorsque le rapport entre la première donnée et la deuxième donnée devient supérieur au troisième seuil, ou à un quatrième seuil différent du troisième seuil et supérieur strictement au premier seuil.

Selon un mode de réalisation, le générateur électrique comprend des cellules photovoltaïques.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de façon partielle et schématique, un mode de réalisation d'un système autonome ;

la figure 2 est un diagramme de fonctionnement d'un mode de réalisation d'un premier procédé de charge de la batterie mis en oeuvre par le système autonome représenté en figure 1 ;

la figure 3 représente des courbes d'évolution en fonction du temps du rapport entre l'énergie disponible pouvant être fournie par le générateur électrique du système autonome et l'énergie consommée par le système autonome de la figure 1, selon différentes conditions de fonctionnement ;

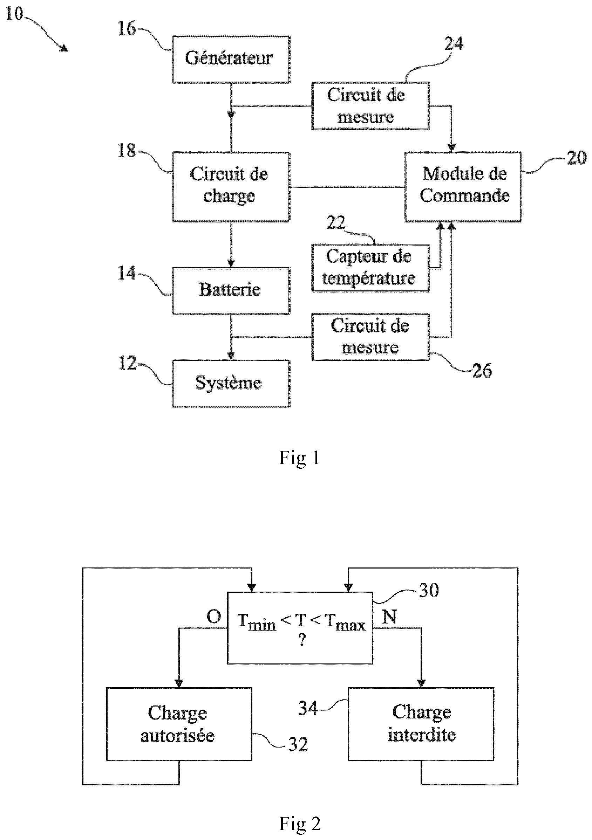

la figure 4 est un diagramme de fonctionnement d'un mode de réalisation d'un deuxième procédé de charge de la

batterie mis en oeuvre par le système autonome représenté en figure 1 ;

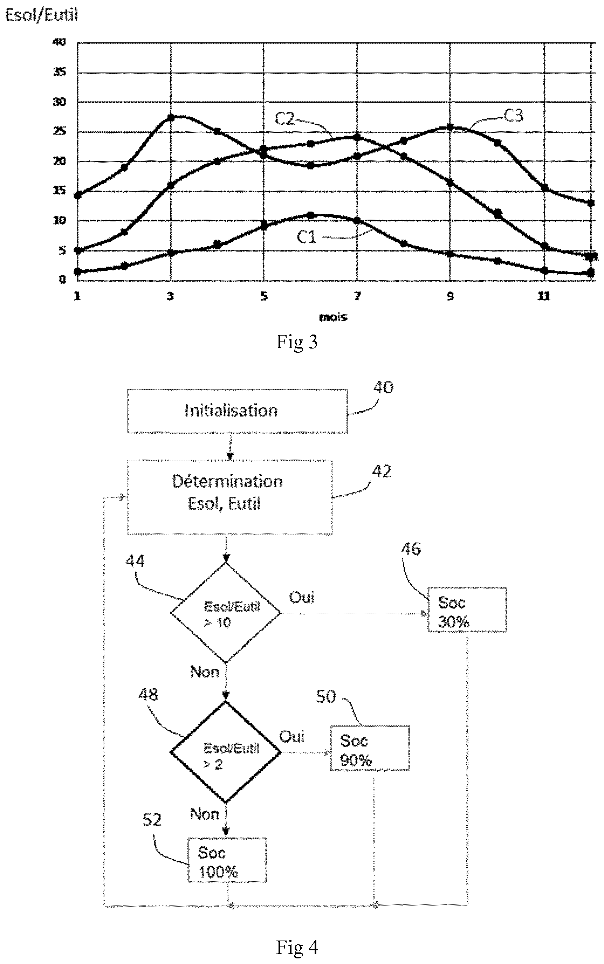

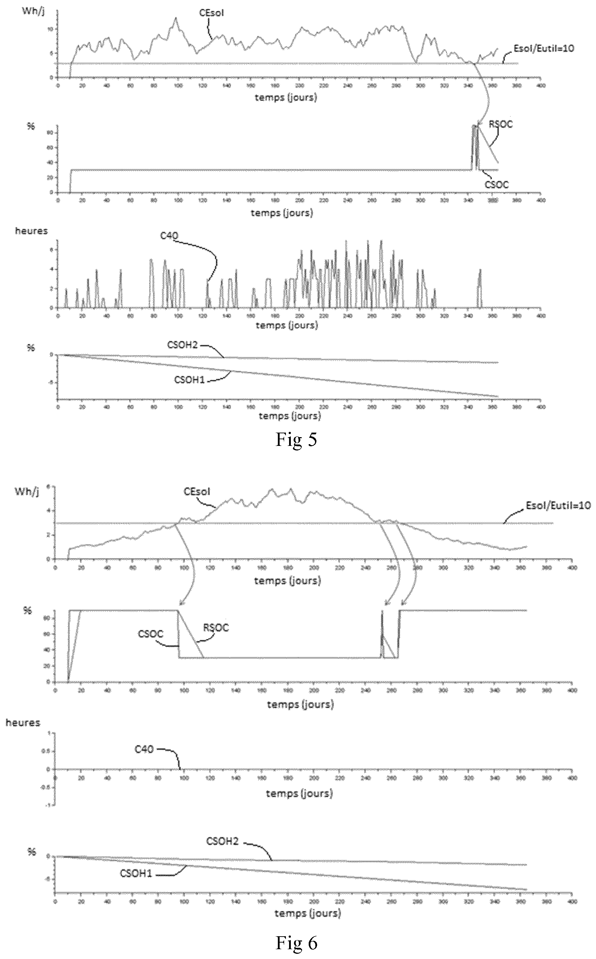

la figure 5 représente des courbes d'évolution en fonction du temps, obtenues par simulation pour le système autonome de la figure 1 dans des conditions météorologiques particulières, de l'énergie disponible pouvant être fournie par le générateur électrique du système autonome, de la consigne d'état de charge (SoC) de la batterie du système autonome, de l'état de charge de la batterie du système autonome, du nombre d'heures pour lequel la température de la batterie du système autonome est supérieure à 40 °C, de l'état de santé de la batterie du système autonome lorsque le procédé de charge illustré en figure 4 n'est pas mis en oeuvre et de l'état de santé de la batterie du système autonome lorsque le procédé de charge illustré en figure 4 est mis en oeuvre ;

la figure 6 représente des courbes d'évolution analogues aux courbes représentées en figure 5 pour des conditions météorologiques différentes ;

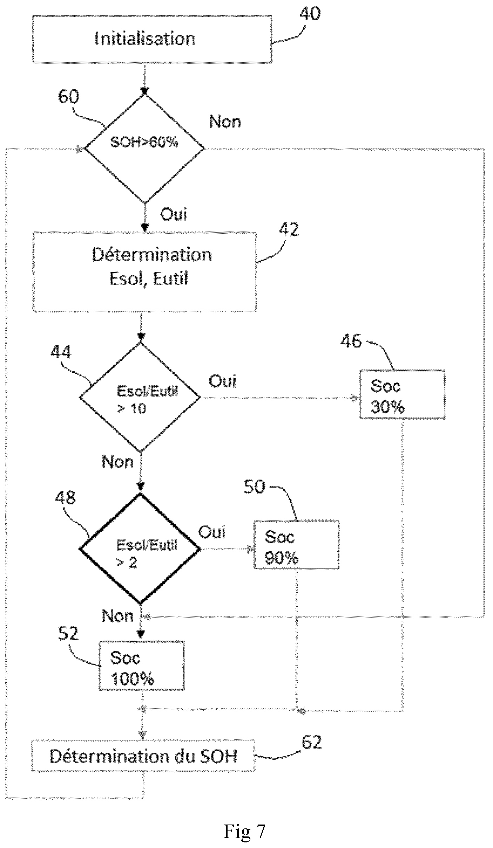

la figure 7 est un diagramme de fonctionnement d'un autre mode de réalisation du deuxième procédé de charge de batterie mis en oeuvre par le système autonome représenté en figure 1 ;

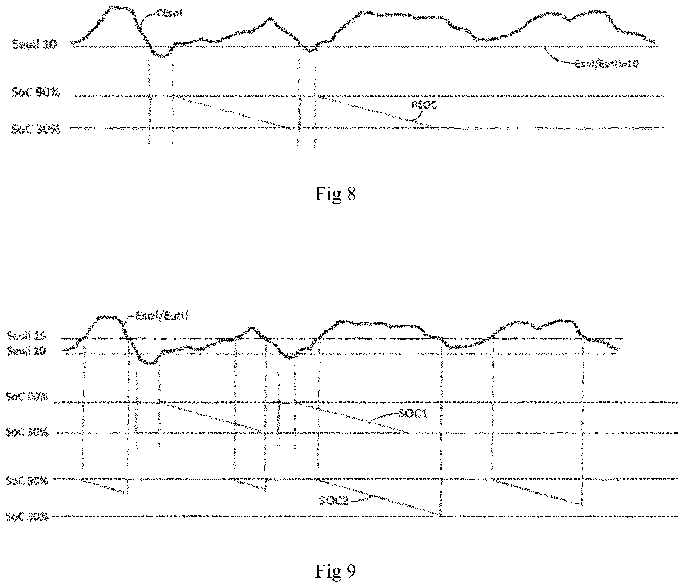

la figure 8 représente des courbes d'évolution en fonction du temps, obtenues par simulation pour le système autonome de la figure 1 dans des conditions météorologiques particulières, de l'énergie disponible pouvant être fournie par le générateur électrique du système autonome et de l'état de charge de la batterie du système autonome lorsque le procédé de charge illustré en figure 4 est mis en oeuvre ; et

la figure 9 représente des courbes d'évolution en fonction du temps, obtenues par simulation pour le système autonome de la figure 1 dans des conditions météorologiques particulières, du rapport entre l'énergie disponible pouvant être fournie par le générateur électrique du système autonome et l'énergie consommée par le système autonome de la figure 1, et de l'état de charge de la batterie pour deux valeurs de seuils mis en oeuvre par le procédé de charge illustré en figure 4.

## Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. En particulier, la structure d'un accumulateur électrique d'une batterie d'accumulateurs est bien connue et n'est pas décrite en détail. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures. Sauf précision contraire, les expressions "approximativement", "sensiblement", et "de l'ordre de" signifient à 10 % près, de préférence à 5 % près.

La figure 1 représente un mode de réalisation d'un système autonome 10 comprenant :

un système électrique ou électromécanique 12 ;
au moins une batterie 14 d'accumulateurs électriques permettant l'alimentation électrique du système électrique ou électromécanique 12 ;
un générateur électrique 16 pour la charge de la batterie 14 ;
un circuit de charge 18 connecté entre le générateur électrique 16 et la batterie 14 ;
un module 20 de commande du circuit de charge 18 ;
un capteur 22 de la température de la batterie 14 relié au module de commande 20 ;
un circuit 24 de mesure de la tension aux bornes du générateur 16 et du courant fourni par le générateur 16, relié au module de commande 20 ; et
un circuit 26 de mesure de la tension aux bornes de la batterie 14 et du courant fourni par la batterie 14, relié au module de commande 20.

Le système électrique ou électromécanique 12 peut correspondre à n'importe quel type de système requérant une alimentation électrique. A titre d'exemple, le système électrique ou électromécanique 12 correspond à un volet roulant électrique, un portail électrique, une fenêtre à ouverture motorisée, ou un élément de mobilier urbain nécessitant une alimentation électrique, par exemple un horodateur ou un équipement d'éclairage public.

Le générateur électrique 16 peut correspondre à n'importe quel type de source d'énergie électrique. Le générateur électrique 16 peut correspondre à un groupe électrogène ou à un centre de production électrique relié à la batterie 14 par le réseau de distribution électrique. De préférence, le générateur électrique 16 est adapté à fournir de

l'énergie électrique à partir d'une énergie renouvelable, par exemple l'énergie solaire, l'énergie éolienne, l'énergie hydraulique ou l'énergie géothermique. A titre d'exemple, le générateur électrique 16 comprend des cellules photovoltaïques adaptées à délivrer en sortie un courant continu et/ou une tension électrique continue lorsqu'elles reçoivent un rayonnement solaire incident, les cellules photovoltaïques étant reliées entre elles, en série ou en parallèle, par l'intermédiaire d'un circuit électrique et/ou pouvant être agencées sur un ou plusieurs panneaux photovoltaïques, l'ensemble des cellules photovoltaïques reliées entre elles étant appelé centrale photovoltaïque 16 dans la suite de la description. Selon un autre exemple, le générateur électrique 16 comprend au moins une éolienne ou un dispositif hydraulique.

La batterie 14 peut correspondre à une batterie d'accumulateurs électriques de n'importe quel type, notamment une batterie lithium, une batterie nickel-hydrure métallique ou une batterie au plomb. Les accumulateurs électriques de la batterie 14 peuvent être montés en série et/ou en parallèle.

Le module de commande 20 peut correspondre à un circuit dédié et/ou peut comprendre un processeur, par exemple un microprocesseur ou un microcontrôleur, adapté à exécuter des instructions d'un programme d'ordinateur stocké dans une mémoire.

Le circuit de charge 18 est un circuit interposé entre le générateur électrique 16 et la batterie 14. Dans le cas où le générateur électrique 16 comprend des cellules photovoltaïques, le circuit de charge 18 peut seulement correspondre à un circuit empêchant la décharge de la batterie 14 dans les cellules photovoltaïques lorsque celles-ci ne produisent pas d'énergie électrique. De façon plus générale, le circuit de charge 18 peut être adapté à convertir la puissance électrique fournie par le générateur 16 en une puissance électrique adaptée à la charge de la batterie 14. Le circuit de charge 18 comprend, par exemple, un convertisseur de tension, par exemple un convertisseur hacheur série (convertisseur Buck).

Le module de commande 20 est adapté à commander le circuit de charge 18 pour mettre en oeuvre un procédé de charge adapté aux spécificités de la batterie 14. Le module de commande 20 est, par exemple, adapté à mettre en oeuvre un procédé de recherche du point de puissance maximal (MPPT, sigle anglais pour Maximum Power Point Tracking). Le module de commande 20 est, en outre, adapté à commander le circuit de charge 18 pour empêcher la charge de la batterie 14 par le générateur électrique 16.

Selon un mode de réalisation, le capteur de température 22 est disposé au contact des accumulateurs de la batterie 14. Selon un mode de réalisation, plusieurs capteurs de température 22 sont présents et disposés au contact des accumulateurs de la batterie 14 à différents emplacements. La température de la batterie 14 peut alors correspondre à la température la plus élevée parmi les températures mesurées par les capteurs de température, ou à une moyenne des températures mesurées par les capteurs de température. Selon un autre mode de réalisation, le capteur de température 22 est adapté à mesurer la température ambiante, c'est-à-dire la température au voisinage de la batterie 14, par exemple à plus de 10 cm de la batterie 14. Le module de commande 18 est alors adapté à estimer la température de la batterie 14 à partir de la température ambiante mesurée, en utilisant des abaques stockées en mémoire.

Le module de commande 20 peut être adapté à déterminer la puissance électrique fournie par le générateur 16 à partir des mesures de la tension et du courant fournies par le circuit de mesure 24. Le module de commande 20 est, en outre, adapté à estimer l'état de charge, appelé SOC (sigle anglais pour State Of Charge) de la batterie 14, par exemple au moyen d'abaques stockées en mémoire, à partir des mesures de la température de la batterie 14 fournie par le capteur de température 22 et des mesures de la tension aux bornes de la batterie 14 et du courant délivré par la batterie 14 fournies par le circuit de mesure 26.

Selon un mode de réalisation, le module de commande 20 met en oeuvre simultanément deux procédés de commande du circuit de charge 18.

Selon un mode de réalisation, le premier procédé de commande vise à empêcher toute opération de charge de la batterie 14 seulement si la température de la batterie 14 est trop élevée ou trop basse, pour éviter une dégradation de la batterie 14.

La figure 2 représente un diagramme de fonctionnement plus détaillé d'un mode de réalisation du premier procédé de commande.

A l'étape 30, le module de commande 20 vérifie si la température de la batterie 14 est comprise entre une température minimale $T_{min}$ et une température maximale $T_{max}$. A titre d'exemple, la température minimale $T_{min}$ est égale à 0 °C. A titre d'exemple, la température maximale $T_{max}$ est comprise entre 40 °C et 60 °C, de préférence entre 45 °C et 50 °C. Si la température de la batterie 14 est comprise entre les températures $T_{min}$ et $T_{max}$, le procédé se poursuit à l'étape 32. Dans le cas contraire, le procédé se poursuit à l'étape 34.

A l'étape 32, le module de commande 20 autorise une opération de charge de la batterie 14. Le procédé se poursuit à l'étape 30.

A l'étape 34, le module de commande 20 empêche toute opération de charge de la batterie 14. Le procédé se poursuit à l'étape 30.

Selon un mode de réalisation, le deuxième procédé de commande du circuit de charge 18 vise, pour une opération de charge de la batterie, à sélectionner une consigne de l'état de charge maximale que peut atteindre la batterie 14 parmi une première valeur appelée consigne basse, une deuxième valeur appelée consigne intermédiaire supérieure à

la consigne basse et une troisième valeur appelée consigne haute supérieure à la consigne intermédiaire. La consigne basse, variant de préférence de 20 % à 50 %, par exemple égale à 30 %, est sélectionnée lorsqu'il y a un risque faible que l'énergie fournie par le générateur 16 du système autonome 10 et pouvant être utilisée pour que la charge de la batterie 14 ne puisse pas compenser l'énergie fournie par la batterie 14 pour l'alimentation du système électrique ou électromécanique 12. La consigne intermédiaire, variant de préférence de 50 % à 95 %, par exemple égale à 90 %, est sélectionnée lorsqu'il y a un risque toujours faible, mais un peu plus élevé que dans le cas précédent, que l'énergie fournie par le générateur 16 du système autonome 10 et pouvant être utilisée pour que la charge de la batterie 14 ne puisse pas compenser l'énergie fournie par la batterie 14 pour l'alimentation du système électrique ou électromécanique 12. La consigne haute, variant de préférence de 95 % à 100 %, par exemple égale à 100 %, est sélectionnée dans les autres cas.

Selon un mode de réalisation, la modification de la consigne d'état de charge maximale est réalisée en comparant à des seuils le rapport Esol/Eutil entre une première donnée Esol, appelée énergie disponible, représentative de l'énergie pouvant être fournie par le générateur 16 sur une première fenêtre temporelle d'analyse, et une deuxième donnée Eutil, appelée énergie consommée, représentative de l'énergie consommée par le système électrique ou électromécanique 12 sur une deuxième fenêtre d'analyse, qui peut être identique à la première fenêtre d'analyse ou différente de la première fenêtre d'analyse.

Le tableau I ci-dessous indique la valeur de la consigne de l'état de charge maximale de la batterie 14 en fonction de la comparaison du rapport Esol/Eutil à des seuils selon un mode de réalisation :

| | Esol/Eutil < seuil bas | Seuil bas < Esol/Eutil < seuil haut | Esol/Eutil > seuil haut |
|---|---|---|---|
| Consigne basse | | | X |
| Consigne intermédiaire | | X | |
| Consigne haute | X | | |

Tableau I

Dans le cas où le générateur électrique 16 comprend des cellules photovoltaïques, la détermination de l'énergie disponible Esol peut comprendre la détermination, pendant plusieurs jours consécutifs, par exemple 10 jours, de l'irradiance globale reçue par les cellules photovoltaïques.

L'irradiance globale ou éclairement énergétique correspond à la puissance d'un rayonnement électromagnétique reçu par un objet par unité de surface. Selon un mode de réalisation, l'irradiance globale mesurée est celle du spectre utile de la lumière du soleil reçue par les cellules photovoltaïques. Dans un plan donné, par exemple celui des panneaux photovoltaïques comprenant les cellules photovoltaïques, l'irradiance globale est la somme de trois composantes :

l'irradiance directe, qui provient directement du soleil, cette composante étant nulle lorsque le soleil est caché par des nuages ou par un obstacle ;
l'irradiance diffuse qui correspond au rayonnement reçu de la voûte céleste, hormis le rayonnement direct ; et
l'irradiance réfléchie qui correspond au rayonnement renvoyé par le sol et l'environnement.

L'irradiance globale peut être déterminée à partir de la mesure du courant de court-circuit de la centrale photovoltaïque 16.

Selon un autre mode de réalisation, notamment dans le cas où le générateur électrique 16 ne comprend pas de cellules photovoltaïques, le module de commande 20 peut déterminer l'énergie disponible Esol sur une fenêtre d'analyse à partir des mesures de la tension et du courant fournies par le circuit de mesure 24.

Selon un mode de réalisation, dans le cas où la tension d'alimentation du système électrique ou électromécanique 12 est constante, l'énergie consommée Eutil peut être déterminée par la mesure du courant consommé par le système électrique ou électromécanique 12. Selon un mode de réalisation, dans le cas où la tension d'alimentation du système électrique ou électromécanique 12 n'est pas constante, l'énergie consommée Eutil peut être déterminée par la mesure du courant consommé par le système électrique ou électromécanique 12 et la mesure de la tension d'alimentation du système électrique ou électromécanique 12. Lorsque le système électrique ou électromécanique 12 comprend un volet roulant, l'énergie consommée Eutil peut être déterminée par la mesure du courant consommé par le moteur électrique d'entraînement du volet roulant à chaque utilisation du volet roulant pendant la fenêtre d'analyse.

Selon un autre mode de réalisation, le module de commande 20 est adapté à déterminer l'énergie consommée Eutil en comptant le nombre d'activations du système électrique ou électromécanique 12 sur la fenêtre d'analyse et en déterminant le produit entre ce nombre d'activations et une estimation de l'énergie consommée pour chaque activation, ou énergie d'activation, stockée en mémoire. Ceci permet de façon avantageuse de ne pas devoir mesurer directement l'énergie consommée par le système électrique ou électromécanique 12.

Lorsque le système électrique ou électromécanique 12 comprend un volet roulant, l'énergie d'activation dépend notamment de la taille du volet qui n'est pas connue à priori par le module de commande 20. L'énergie d'activation peut être estimée par le module de commande 20 par la durée de la course allant de l'ouverture à la fermeture du volet roulant ou de la fermeture à l'ouverture du volet roulant. Selon un mode de réalisation, il est stocké dans une mémoire du module de commande 20 un tableau de correspondance entre la durée d'ouverture ou de fermeture du volet et l'énergie d'activation pour toutes les tailles possibles de volet roulant. A la première utilisation du volet roulant, le module de commande 20 est adapté à mesurer la durée d'ouverture ou de fermeture du volet et à sélectionner dans le tableau la valeur adaptée de l'énergie d'activation. Selon un autre exemple, l'énergie d'activation peut être mesurée une fois, par exemple à l'installation du volet roulant, par exemple par la mesure du courant consommé par le volet roulant et la mesure de la tension d'alimentation du volet roulant au cours d'une activation du volet roulant.

Les seuils auxquels est comparé le rapport Esol/Eutil peuvent être déterminés au préalable et stockés dans une mémoire du module de commande 20. Les seuils dépendent de l'application visée et notamment de l'importance accordée à la contrainte d'autonomie de fonctionnement du système autonome, également appelé continuité de service, et à la contrainte de maximisation de la durée de vie de la batterie 14.

La figure 3 représente des courbes d'évolution C1, C2 et C3, obtenues par simulation, du rapport Esol/Eutil dans un mode de réalisation dans lequel le générateur électrique 16 comprend des cellules photovoltaïques orientées respectivement au nord, à l'est et au sud et dans lequel le système électrique ou électromécanique 12 comprend un volet roulant. Dans cet exemple, le rapport Esol/Eutil évolue de 1 à 27.

A partir de nombreuses simulations analogues à celle de la figure 3, les inventeurs ont défini des seuils dans un mode de réalisation dans lequel le générateur électrique 16 comprend des cellules photovoltaïques et dans lequel le système électrique ou électromécanique 12 comprend un volet roulant.

Selon un mode de réalisation d'un procédé de commande de la valeur de la consigne de l'état de charge maximale de la batterie 14 selon le tableau I précédent, l'état de charge maximale que peut atteindre la batterie 14 est la consigne haute lorsque le rapport Esol/Eutil est inférieur strictement au seuil bas, compris entre 1 et 3. Le seuil bas permet de conserver une marge de ressource énergétique pour assurer la continuité de service. L'état de charge maximale que peut atteindre la batterie 14 est la consigne intermédiaire lorsque le rapport Esol/Eutil est supérieur strictement au seuil bas et inférieur ou égal au seuil haut compris entre 3 et 15. Le seuil haut permet de conserver une marge de ressource énergétique pour que l'état de charge puisse remonter facilement à 100 % en cas de conditions d'irradiance devenant moins favorables. L'état de charge maximale que peut atteindre la batterie 14 est la consigne basse lorsque le rapport Esol/Eutil est supérieur strictement au seuil haut. Ce seuil permet de conserver une marge de ressource énergétique élevée. Ceci permet à la fois de garantir la possibilité de remonter rapidement l'état de charge à la consigne intermédiaire en cas de conditions d'irradiance devenant moins favorables et en même temps de prévenir les conditions de surchauffe. Ce seuil est de préférence défini pour les conditions environnementales les plus pénalisantes vis-à-vis des hautes températures de la batterie 14.

La figure 4 représente un diagramme de fonctionnement d'un mode de réalisation du deuxième procédé de commande du circuit de charge 18.

L'étape 40 correspond à un état d'initialisation dans lequel se place automatiquement le module de commande 20 au premier démarrage du système autonome 10, par exemple à la mise sous tension du système autonome 10. Selon un mode de réalisation, à l'étape 40, une opération de charge de la batterie 14 est autorisée selon un mode de fonctionnement défini par défaut, par exemple à la consigne intermédiaire. Ceci permet, de façon avantageuse, si la batterie 14 est partiellement déchargée à la mise sous tension du système autonome 10, de commencer immédiatement à compléter sa charge. Le procédé se poursuit à l'étape 42.

A l'étape 42, le module de commande 20 détermine de nouvelles valeurs de l'énergie disponible Esol et de l'énergie consommée Eutil. Le module de commande 20 détermine alors une nouvelle valeur du rapport Esol/Eutil.

Selon un mode de réalisation, pour déterminer le rapport Esol/Eutil, le module de commande 20 détermine la

moyenne des valeurs de l'énergie disponible Esol déterminées sur une fenêtre d'analyse de plusieurs jours consécutifs, de préférence 10 jours, pour être représentative d'une tendance globale de l'évolution des conditions météorologiques. Pour déterminer le rapport Esol/Eutil, le module de commande 20 détermine la moyenne des valeurs de l'énergie consommée Eutil déterminées sur la fenêtre d'analyse de plusieurs jours consécutifs, de préférence 10 jours, pour être représentative d'une tendance globale de la consommation du système électrique ou électromécanique 12.

Les valeurs de l'énergie disponible Esol sont, par exemple, déterminées à intervalles réguliers, de préférence toutes les 5 minutes. Il est avantageux que le pas de mesure soit inférieur à 60 minutes pour que la détermination de l'énergie disponible Esol soit peu modifiée par de fortes variations sur de courtes durées de l'irradiance, par exemple lorsque le soleil est brièvement caché par des nuages. Les valeurs de l'énergie consommée Eutil peuvent être déterminées à chaque utilisation du système électrique ou électromécanique 12.

A titre d'exemple, la détermination d'une nouvelle valeur du rapport Esol/Eutil est réalisée à chaque nouvelle valeur de l'énergie disponible Esol ou de l'énergie consommée Eutil avec les mesures précédentes de l'énergie disponible Esol ou de l'énergie consommée Eutil réalisées pendant la fenêtre d'analyse qui se termine avec la dernière mesure réalisée. Selon un autre exemple, la détermination d'une nouvelle valeur du rapport Esol/Eutil est réalisée à intervalles réguliers, de préférence une fois par jour avec les mesures de l'énergie disponible Esol et de l'énergie consommée Eutil réalisées pendant la fenêtre d'analyse.

Selon un mode de réalisation, au début du fonctionnement du système autonome 10, le rapport Esol/Eutil est déterminé avec les valeurs mesurées sur le nombre de jours de fonctionnement du système autonome 10 jusqu'à ce que la durée de la fenêtre d'analyse soit atteinte. Le procédé se poursuit à l'étape 44.

A l'étape 44, le module de commande 20 compare la nouvelle valeur du rapport Esol/Eutil avec le seuil haut. Si le rapport Esol/Eutil est supérieur strictement au seuil haut, le procédé se poursuit à l'étape 46. Si le rapport Esol/Eutil est inférieur ou égal au seuil haut, le procédé se poursuit à l'étape 48.

A l'étape 46, le module de commande 20 passe dans un mode de fonctionnement, appelé mode bas, dans lequel la consigne d'état de charge maximale de la batterie 14 est la consigne basse. Le procédé de charge de la batterie 14, c'est-à-dire la commande du circuit de charge 18 par le module de commande 20, peut être spécifique dans le mode bas. A titre d'exemple, le courant maximal de charge de la batterie 14 peut être maximum. A titre de variante, le procédé de charge de la batterie 14 dans le mode bas peut être identique au procédé de charge de la batterie dans le mode intermédiaire et/ou le mode haut, seule la consigne d'état de charge maximale de la batterie étant différente. Le mode de fonctionnement bas se poursuit tant qu'il n'y a pas de passage dans un autre mode de fonctionnement et tant qu'il n'y a pas d'interruption de charge demandée par le premier procédé de fonctionnement décrit précédemment. Le procédé se poursuit à l'étape 42.

A l'étape 48, le module de commande 20 compare la nouvelle valeur du rapport Esol/Eutil avec le seuil bas. Si le rapport Esol/Eutil est supérieur strictement au seuil bas, le procédé se poursuit à l'étape 50. Si le rapport Esol/Eutil est inférieur ou égal au seuil bas, le procédé se poursuit à l'étape 52.

A l'étape 50, le module de commande 20 passe dans un mode de fonctionnement, appelé mode intermédiaire, dans lequel la consigne d'état de charge maximale de la batterie 14 est la consigne intermédiaire. Le procédé de charge de la batterie 14, c'est-à-dire la commande du circuit de charge 18 par le module de commande 20, peut être spécifique dans le mode de fonctionnement intermédiaire. A titre de variante, le procédé de charge de la batterie 14 dans le mode intermédiaire peut être identique au procédé de charge de la batterie dans le mode bas et/ou le mode haut, seule la consigne d'état de charge maximale de la batterie étant différente. Le mode intermédiaire se poursuit tant qu'il n'y a pas de passage dans un autre mode de fonctionnement et tant qu'il n'y a pas d'interruption de charge demandée par le premier procédé de fonctionnement décrit précédemment. Le procédé se poursuit à l'étape 42.

A l'étape 52, le module de commande 20 passe dans un mode de fonctionnement, appelé mode haut, dans lequel la consigne d'état de charge maximale de la batterie 14 est la consigne haute. Le procédé de charge de la batterie 14, c'est-à-dire la commande du circuit de charge 18 par le module de commande 20, peut être spécifique dans le mode haut. A titre d'exemple, le courant maximal de charge de la batterie 14 peut être limité. A titre de variante, le procédé de charge de la batterie 14 dans le mode haut peut être identique au procédé de charge de la batterie dans le mode bas et/ou le mode intermédiaire, seule la consigne d'état de charge maximale de la batterie étant différente. Le mode haut se poursuit tant qu'il n'y a pas de passage dans un autre mode de fonctionnement et tant qu'il n'y a pas d'interruption de charge demandée par le premier procédé de fonctionnement décrit précédemment. Le procédé se poursuit à l'étape 42.

Les étapes de comparaison 44 et 48 peuvent être réalisées à chaque détermination d'une nouvelle valeur du rapport Esol/Eutil ou à intervalles réguliers, de préférence une fois par jour.

Pour évaluer une amélioration de la durée de vie de la batterie 14, on peut déterminer l'état de santé ou SOH (sigle anglais pour State Of Health) de la batterie 14. La détermination de l'état de santé de la batterie peut être réalisée sur la base de modèles de vieillissement de la batterie 14 qui prennent en compte notamment :

- la quantité d'énergie délivrée par la batterie 14 au fil de sa vie ;
- le temps passé par la batterie 14 à différents niveaux de température ;
- la durée de fonctionnement du système autonome 10.

Un exemple de procédé de détermination de l'état de santé d'une batterie est décrit dans l'ouvrage intitulé "Electrochemical Energy Storage for Renewable Sources and Grid Balancing" au chapitre 20 intitulé "Battery management and battery diagnostics" rédigé par Angel Kirchev (2015 Elsevier B.V, pages 411-435).

La figure 5 représente des courbes d'évolution CEsol, CSOC, RSOC, C40, CSOH1 et CSOH2 sur une année obtenues par simulations pour un système autonome 10 comprenant des cellules photovoltaïques orientées au sud. Les simulations sont présentées sur la base de données météorologiques d'irradiance sur un site particulier.

La courbe CEsol est la courbe d'évolution en fonction du temps de l'énergie disponible Esol pouvant être fournie par le générateur 16 du système autonome 10. La courbe CSOC est la courbe d'évolution en fonction du temps de la consigne d'état de charge de la batterie 14. La courbe RSOC est la courbe d'évolution en fonction du temps de l'état de charge de la batterie 14. La courbe C40 est la courbe d'évolution en fonction du temps du nombre d'heures pour lequel la température de la batterie 14 est supérieure à 40 °C. La courbe CSOH1 est la courbe d'évolution en fonction du temps de l'état de santé de la batterie 14 lorsque le procédé de charge illustré en figure 4 n'est pas mis en oeuvre et la courbe CSOH2 est la courbe d'évolution en fonction du temps de l'état de santé de la batterie 14 lorsque le procédé de charge illustré en figure 4 est mis en oeuvre.

Comme le montre la courbe RSOC, l'état de charge de la batterie 14 est à 30 % la plupart du temps, excepté une courte période d'intersaison où les conditions d'irradiance deviennent plus défavorables (c'est-à-dire que le rapport Esol/Eutil est inférieur à 10). Il s'ensuit une montée rapide de l'état de charge de la batterie à 90 %. On peut vérifier que cette période correspond à des températures de batterie modérées (inférieures à 40 °C). Le gain sur le vieillissement de la batterie est mis en évidence en considérant le temps passé à température élevée, soit une diminution de 1 % de l'état de santé de la batterie 14 lorsque le procédé de charge illustré en figure 4 est mis en oeuvre et une diminution de 7 % de l'état de santé de la batterie 14 lorsque le procédé de charge illustré en figure 4 n'est pas mis en oeuvre.

La figure 6 représente des courbes d'évolution analogues aux courbes représentées en figure 5, obtenues par simulations sur une année pour un système autonome 10 comprenant des cellules photovoltaïques orientées au nord, c'est-à-dire en situation d'exposition plus défavorable. Comme le montre la courbe RSOC, l'état de charge est à 90 % aux intersaisons et à 30 % en été pour un critère de passage à Esol/Eutil égal à 10. Dans ce cas la température de la batterie 14 est toujours modérée (c'est-à-dire inférieure à 40 °C). Toutefois, la mise en oeuvre du procédé de charge illustré en figure 4 permet de réduire le vieillissement de la batterie puisque l'on observe une diminution de 2 % de l'état de santé de la batterie 14 lorsque le procédé de charge illustré en figure 4 est mis en oeuvre et une diminution de 7 % de l'état de santé de la batterie 14 lorsque le procédé de charge illustré en figure 4 n'est pas mis en oeuvre.

Comme cela apparaît sur les simulations, en situation de fort ensoleillement où la température de batterie atteint des valeurs favorisant le vieillissement (c'est-à-dire supérieure à 40 °C), l'état de charge est limité à 30 %, et en situation de faible éclairement où les températures de batterie restent limitées, l'état de charge est de 90 %.

Une explication du gain sur le vieillissement de la batterie est que le procédé de charge tend à commander un taux de charge le plus bas possible tout en satisfaisant le critère de continuité de service. Le vieillissement de la batterie 14 est alors réduit et ce d'autant plus que la température est élevée.

On peut observer que le vieillissement avec la mise en oeuvre du procédé de charge illustré en figure 4 est plus prononcé pour les simulations illustrées en figure 6 concernant une exposition au nord des cellules photovoltaïques du système autonome 10 que pour les simulations illustrées en figure 5 qui concernent une exposition au sud des cellules photovoltaïques du système autonome 10. Une explication est que l'état de charge de la batterie 14 est plus élevé dans le cas de l'exposition nord que de l'exposition sud. Les conditions de température plus favorables dans le cas de l'exposition nord n'améliorent donc pas la durée de vie de la batterie car l'état de charge reste élevé pendant une période plus importante. Le procédé de charge illustré en figure 4 permet de façon avantageuse d'augmenter la durée de vie de la batterie même dans ce cas.

De façon générale, en fin de vie, la capacité maximale de stockage des batteries se dégrade progressivement. Il peut alors ne plus être possible d'assurer la continuité de service du système autonome. Il peut alors ne plus être judicieux de conserver un régime de charge partielle de la batterie 14 sous peine de ne pas profiter pleinement de la capacité des batteries. Selon un mode de réalisation, à partir d'un certain niveau d'état de santé, on autorise en permanence la charge de la batterie à 100 % de façon à assurer la continuité de service jusqu'au vieillissement ultime de la batterie.

La figure 7 est un diagramme de fonctionnement d'un autre mode de réalisation du deuxième procédé de charge de batterie mis en oeuvre par le système autonome 10 représenté en figure 1. Les étapes communes avec le mode de réalisation du deuxième procédé de charge décrit précédemment en relation avec la figure 4 sont indiquées avec les mêmes références.

Le procédé débute à l'étape 40 d'initialisation décrite précédemment. A cette étape, le module de commande 20 initialise en outre l'état de santé de la batterie à 100 %. Le procédé se poursuit à l'étape 60.

A l'étape 60, le module de commande 20 compare l'état de santé de la batterie 14 à un seuil compris entre 50 % et 70 %, par exemple égal à 60 %. Si l'état de santé est supérieur strictement au seuil, le procédé se poursuit à l'étape 42 décrite précédemment. Si l'état de santé est inférieur ou égal au seuil, le procédé se poursuit à l'étape 52 décrite précédemment.

Après l'exécution des étapes 46, 50 et 52 décrites précédemment, le procédé ne se poursuit pas à l'étape 42 comme pour le mode de réalisation du procédé de commande décrit précédemment en relation avec la figure 4, mais, dans le présent mode de réalisation, le procédé se poursuit à l'étape 62.

A l'étape 62, le module de commande 20 détermine l'état de santé de la batterie 14. Selon un mode de réalisation, pour déterminer l'état de santé, le module de commande 20 peut déterminer le nombre d'heures passées par la batterie 14 entre 30 °C et 40 °C, le nombre d'heures passées par la batterie 14 entre 40 °C et 50 °C et le nombre d'heures passées par la batterie 14 entre 50 °C et 60 °C. Le module de commande 20 peut, en outre, déterminer la quantité d'énergie fournie par la batterie 14 depuis sa mise en service. Le module de commande 20 peut, en outre, déterminer la durée totale de fonctionnement de la batterie 14. Le procédé se poursuit à l'étape 60.

Selon un autre mode de réalisation, la détermination de l'état de santé de la batterie 14 peut être obtenue par la détermination de l'énergie consommée par le système électrique ou électromécanique 12 entre deux niveaux identifiables de l'état de charge de la batterie 14, par exemple 90 % et 30 %, puis la comparaison de cette énergie aux performances initiales de la batterie 14. Selon un autre mode de réalisation, la détermination de l'état de santé peut comprendre le comptage du nombre d'activations du système électrique ou électromécanique 12 entre deux niveaux identifiables de l'état de charge de la batterie 14, par exemple 90 % et 30 %, puis par comparaison de cette énergie aux performances initiales de la batterie 14. La détermination d'une nouvelle valeur de l'état de santé peut être mise en oeuvre périodiquement (par exemple toutes les 500 activations du système électrique ou électromécanique 12) pendant une période où l'irradiance est élevée de sorte que l'état de charge de la batterie 14 puisse descendre à la consigne basse, par exemple 30 %. Dans le cas où l'état de charge de la batterie 14 ne descend jamais à la consigne basse, par exemple dans le cas d'une exposition défavorable, l'état de santé peut ne pas être calculé par le procédé comprenant le comptage du nombre d'activations du système électrique ou électromécanique 12 entre deux niveaux identifiables de l'état de charge de la batterie 14, par exemple 90 % et 30 %, car l'état de charge de la batterie 14 est élevé en permanence (à la consigne intermédiaire, par exemple 90 %, ou à la consigne haute, par exemple 100 %), mais peut être calculé par d'autres méthodes.

De façon avantageuse, la mise en oeuvre des procédés de charge décrits précédemment ne nécessite pas la détermination de la date du jour par le module de commande 20. La détermination du mode de fonctionnement du système autonome 10 est réalisée automatiquement lors de sa mise en route.

Des modes de réalisation particuliers ont été décrits. Diverses variantes et modifications apparaîtront à l'homme de l'art.

En particulier, dans des modes de réalisation décrits précédemment, la durée de calcul de la moyenne de l'énergie disponible Esol et de l'énergie consommée Eutil est de 10 jours quel que soit le mode de fonctionnement du système autonome 10. Toutefois, cette durée peut être différente selon le mode de fonctionnement du module de commande 20.

Lorsqu'on souhaite privilégier la continuité de service, il peut être souhaitable d'augmenter la réactivité du module de commande 20 lorsqu'il s'agit d'aller vers les états de charge de la batterie 14 élevés. Dans ce cas, la durée de calcul à l'étape 42 de la moyenne de l'énergie disponible Esol et de l'énergie consommée Eutil peut être moins longue dans le mode haut que dans le mode intermédiaire et peut être moins longue dans le mode intermédiaire que dans le mode bas. A titre d'exemple, dans le mode haut, dans lequel la consigne d'état de charge maximale de la batterie 14 est par exemple de 100 %, la durée de calcul de la moyenne de l'énergie disponible Esol et de l'énergie consommée Eutil peut être inférieure à 10 jours, par exemple égale à 6 jours. Dans le mode de fonctionnement intermédiaire, dans lequel la consigne d'état de charge maximale est par exemple de 90 %, la durée de calcul de la moyenne de l'énergie disponible Esol et de l'énergie consommée Eutil peut être inférieure à 10 jours, par exemple égale à 8 jours et dans le mode de fonctionnement bas, dans lequel la consigne d'état de charge maximale est par exemple de 30 %, la durée de calcul de la moyenne de l'énergie disponible Esol et de l'énergie consommée Eutil peut être laissée à 10 jours.

Lorsqu'on souhaite privilégier la durée de vie de la batterie sur la continuité de service, il peut être souhaitable de diminuer la réactivité du module de commande 20 lorsqu'il s'agit d'aller vers les états de charge élevés. Dans ce cas, la durée de calcul à l'étape 42 de la moyenne de l'énergie disponible Esol et de l'énergie consommée Eutil peut être plus longue dans le mode haut que dans le mode intermédiaire et peut être plus longue dans le mode intermédiaire que dans le mode bas. A titre d'exemple, dans le mode de fonctionnement haut, la durée de calcul de la moyenne de l'énergie disponible Esol et de l'énergie consommée Eutil peut être laissée à 10 jours. Dans le mode de fonctionnement intermédiaire, la durée de calcul de la moyenne de l'énergie disponible Esol et de l'énergie consommée Eutil peut être inférieure à 10 jours, par exemple égale à 8 jours et dans le mode de fonctionnement bas, la durée de calcul de la moyenne de l'énergie disponible Esol et de l'énergie consommée Eutil peut être inférieure à 10 jours, par exemple égale à 6 jours.

En particulier, dans les modes de réalisation décrits précédemment, la durée de la fenêtre d'analyse pour le calcul de la moyenne de l'énergie disponible Esol et de l'énergie consommée Eutil est constante au cours du fonctionnement du système autonome 10. Toutefois, cette durée de la fenêtre d'analyse peut ne pas être optimale notamment en fonction de la localisation géographique du système autonome 10 et de l'exposition du système autonome 10. En effet, elle a généralement été obtenue après de nombreux essais pour tenir compte des cas les plus défavorables.

La figure 8 représente des courbes d'évolution CEsol et RSOC en fonction du temps, obtenues par simulation dans des conditions météorologiques particulières, respectivement de l'énergie disponible pouvant être fournie par le générateur 16 du système autonome 10 et de l'état de charge de la batterie 14, lorsque le procédé de charge illustré en figure 4 est mis en oeuvre. Comme cela apparaît sur cette figure, l'état de charge bascule à deux reprises à 90 % alors que le rapport Esol/Eutil est pratiquement tout le temps supérieur à 10. Ceci signifie que la durée de la fenêtre d'analyse n'est pas optimale et qu'elle devrait être augmentée. En effet, en augmentant la durée de la fenêtre d'analyse, on augmente l'effet de lissage, ce qui permet de supprimer les courtes périodes où le module 20 commande la montée de l'état de charge de la batterie 14 à 90 % sans réelle nécessité.

Selon un mode de réalisation, la durée de la fenêtre d'analyse utilisée pour le calcul de la moyenne de l'énergie disponible Esol et de l'énergie consommée Eutil peut être modifiée au cours du fonctionnement du système autonome 10. Selon un mode de réalisation, à la première mise en service du système autonome 10, la valeur de la durée de la fenêtre d'analyse utilisée est une valeur stockée dans une mémoire du module de commande 20. Le module de commande 20 détermine une nouvelle valeur de la durée de la fenêtre d'analyse en fonction du comportement du système autonome 10 pendant une certaine période, par exemple un an, pour que le système autonome 10 ait fonctionné dans toutes les saisons.

Le module de commande 20 peut déterminer au bout de la période les états de charge réellement atteints et les valeurs des rapports Esol/Eutil pour chaque niveau d'état de charge. Le module de commande 20 peut alors mettre à jour les durées des fenêtres d'analyse pour chaque mode haut, intermédiaire et bas lorsque ces durées sont différentes selon le mode de fonctionnement du système autonome, ou mettre à jour la durée de la fenêtre d'analyse lorsque celle-ci est commune aux modes haut, intermédiaire et bas. Le présent mode de réalisation permet d'améliorer la réduction du vieillissement de la batterie.

Selon un autre mode de réalisation, on peut favoriser plus ou moins les états de charge bas. Lorsque l'on souhaite privilégier la continuité de service, il est possible de sélectionner des valeurs plutôt hautes pour les seuils bas et haut. Par exemple, le seuil bas peut être égal à 2 et le seuil haut être égal à 10. Lorsque l'on souhaite favoriser la durée de vie de la batterie 14, il est possible de sélectionner des valeurs plutôt basses pour le seuil bas et haut. Par exemple, le seuil bas peut être égal à 1,5 et le seuil haut être égal à 5.

La figure 9 représente une courbe d'évolution du rapport Esol/Eutil, une courbe SOC1 d'évolution de l'état de charge de la batterie lorsque le seuil haut est égal à 10 et une courbe SOC2 d'évolution de l'état de charge de la batterie lorsque le seuil haut est égal à 15. On note que pour la courbe SOC2, l'état de charge de la batterie est maintenu plus fréquemment à 90 % que pour la courbe SOC1.

Selon un autre mode de réalisation qui ne fait pas partie de l'invention, dans le cas où le générateur électrique 16 est adapté à fournir une énergie électrique sensiblement constante dans le temps, par exemple lorsque le générateur électrique 16 correspond à un groupe électrogène ou à un centre de production électrique relié à la batterie 14 par le réseau de distribution électrique, la gestion de l'état de charge de la batterie peut être déduite de la température de la batterie en mesurant le nombre journalier d'heures passées au-dessus d'un seuil de température. Selon un mode de réalisation, si ce nombre est inférieur à un seuil de nombre d'heures, la consigne de l'état de charge maximale est la consigne intermédiaire, sinon la consigne de l'état de charge est la consigne basse. Par exemple 2 heures sur une période de 24 heures à une température supérieure à 40 °C entraine une charge avec la consigne basse (par exemple 0 % à 50 %), sinon une charge avec la consigne intermédiaire (par exemple 50 % à 95 %).

En outre, dans des modes de réalisation décrits précédemment, la modification de la consigne d'état de charge maximale de la consigne basse à la consigne intermédiaire est réalisée en comparant le rapport Esol/Eutil au seuil haut. A titre de variante, la modification de la consigne d'état de charge maximale de la consigne basse à la consigne intermédiaire peut être réalisée lorsque le rapport Esol/Eutil devient inférieur à un premier seuil haut tandis que la modification de la consigne d'état de charge maximale de la consigne intermédiaire à la consigne basse peut être réalisée lorsque le rapport Esol/Eutil devient supérieur à un deuxième seuil haut différent du premier seuil haut. En outre, dans des modes de réalisation décrits précédemment, la modification de la consigne d'état de charge maximale de la consigne intermédiaire à la consigne haute est réalisée en comparant le rapport Esol/Eutil au seuil bas. A titre de variante, la modification de la consigne d'état de charge maximale de la consigne intermédiaire à la consigne haute peut être réalisée lorsque le rapport Esol/Eutil devient inférieur à un premier seuil bas tandis que la modification de la consigne d'état de charge maximale de la consigne haute à la consigne intermédiaire peut être réalisée lorsque le rapport Esol/Eutil devient supérieur à un deuxième seuil bas différent du premier seuil bas.

Selon un autre mode de réalisation, on peut favoriser plus ou moins les états de charge bas. Lorsque l'on souhaite privilégier la continuité de service, il est possible de sélectionner des valeurs plutôt hautes pour les seuils bas et haut. Par exemple, le seuil bas peut être égal à 2 et le seuil haut être égal à 10. Lorsque l'on souhaite favoriser la durée de vie de la batterie 14, il est possible de sélectionner des valeurs plutôt basses pour le seuil bas et haut. Par exemple, le seuil bas peut être égal à 1,5 et le seuil haut être égal à 5.

La figure 9 représente une courbe d'évolution du rapport Esol/Eutil, une courbe SOC1 d'évolution de l'état de charge de la batterie lorsque le seuil haut est égal à 10 et une courbe SOC2 d'évolution de l'état de charge de la batterie

lorsque le seuil haut est égal à 15. On note que pour la courbe SOC2, l'état de charge de la batterie est maintenu plus fréquemment à 90 % que pour la courbe SOC1.

Selon un autre mode de réalisation, dans le cas où le générateur électrique 16 est adapté à fournir une énergie électrique sensiblement constante dans le temps, par exemple lorsque le générateur électrique 16 correspond à un groupe électrogène ou à un centre de production électrique relié à la batterie 14 par le réseau de distribution électrique, la gestion de l'état de charge de la batterie peut être déduite de la température de la batterie en mesurant le nombre journalier d'heures passées au-dessus d'un seuil de température. Selon un mode de réalisation, si ce nombre est inférieur à un seuil de nombre d'heures, la consigne de l'état de charge maximale est la consigne intermédiaire, sinon la consigne de l'état de charge est la consigne basse. Par exemple 2 heures sur une période de 24 heures à une température supérieure à 40 °C entraine une charge avec la consigne basse (par exemple 0 % à 50 %), sinon une charge avec la consigne intermédiaire (par exemple 50 % à 95 %).

En outre, dans des modes de réalisation décrits précédemment, la modification de la consigne d'état de charge maximale de la consigne basse à la consigne intermédiaire est réalisée en comparant le rapport Esol/Eutil au seuil haut. A titre de variante, la modification de la consigne d'état de charge maximale de la consigne basse à la consigne intermédiaire peut être réalisée lorsque le rapport Esol/Eutil devient inférieur à un premier seuil haut tandis que la modification de la consigne d'état de charge maximale de la consigne intermédiaire à la consigne basse peut être réalisée lorsque le rapport Esol/Eutil devient supérieur à un deuxième seuil haut différent du premier seuil haut. En outre, dans des modes de réalisation décrits précédemment, la modification de la consigne d'état de charge maximale de la consigne intermédiaire à la consigne haute est réalisée en comparant le rapport Esol/Eutil au seuil bas. A titre de variante, la modification de la consigne d'état de charge maximale de la consigne intermédiaire à la consigne haute peut être réalisée lorsque le rapport Esol/Eutil devient inférieur à un premier seuil bas tandis que la modification de la consigne d'état de charge maximale de la consigne haute à la consigne intermédiaire peut être réalisée lorsque le rapport Esol/Eutil devient supérieur à un deuxième seuil bas différent du premier seuil bas.

## Revendications

1. Procédé de charge d'une batterie (14) d'accumulateurs électriques à partir de l'énergie électrique fournie par un générateur électrique (16), dans lequel la batterie est chargée à un premier état de charge maximale dans un premier mode de fonctionnement et à un deuxième état de charge maximale, strictement inférieur au premier état de charge maximale, dans un deuxième mode de fonctionnement, **caractérisé en ce que** le procédé comprend le passage du deuxième mode de fonctionnement au premier mode de fonctionnement lorsque le rapport entre une première donnée représentative de l'énergie disponible pouvant être fournie par le générateur électrique et une deuxième donnée représentative de l'énergie consommée depuis la batterie devient inférieur à un premier seuil.

2. Procédé selon la revendication 1, comprenant le passage du premier mode de fonctionnement au deuxième mode de fonctionnement lorsque le rapport entre la première donnée représentative de l'énergie disponible pouvant être fournie par le générateur électrique et la deuxième donnée représentative de l'énergie consommée depuis la batterie devient supérieur au premier seuil ou à un deuxième seuil différent du premier seuil.

3. Procédé selon la revendication 1 ou 2, dans lequel la batterie (14) est chargée à un troisième état de charge maximale strictement inférieur au deuxième état de charge maximale dans un troisième mode de fonctionnement, le procédé comprenant le passage du troisième mode de fonctionnement au deuxième mode de fonctionnement lorsque le rapport entre la première donnée et la deuxième donnée devient inférieur à un troisième seuil supérieur strictement au premier seuil.

4. Procédé selon la revendication 3, comprenant le passage du deuxième mode de fonctionnement au troisième mode de fonctionnement lorsque le rapport entre la première donnée et la deuxième donnée devient supérieur au troisième seuil, ou à un quatrième seuil différent du troisième seuil et supérieur strictement au premier seuil.

5. Procédé selon la revendication 3 ou 4, dans lequel le premier état de charge maximale varie de 95 % à 100 %, dans lequel le deuxième état de charge maximale varie de 50 % à 95 %, et dans lequel le troisième état de charge maximale varie de 20 % à 50 %.

6. Procédé selon l'une quelconque des revendications 3 à 5, dans lequel le premier seuil varie de 1 à 3 et dans lequel le troisième seuil varie de 3 à 15.

7. Procédé selon l'une quelconque des revendications 1 à 6, dans lequel le générateur électrique (16) comprend des

cellules photovoltaïques.

8. Procédé selon la revendication 7, dans lequel la première donnée est déterminée à partir de la mesure de l'irradiance globale reçue par les cellules photovoltaïques.

9. Procédé selon l'une quelconque des revendications 1 à 8, comprenant la détermination de premières valeurs sur une fenêtre temporelle, la détermination de la première donnée comprenant la détermination de la moyenne des premières valeurs sur la fenêtre temporelle, le procédé comprenant, en outre, la détermination de deuxièmes valeurs, la détermination de la deuxième donnée comprenant la détermination de la moyenne des deuxièmes valeurs sur la fenêtre temporelle.

10. Procédé selon la revendication 9, dans lequel la durée de la fenêtre temporelle dans le premier mode de fonctionnement est différente de la durée de la fenêtre temporelle dans le deuxième mode de fonctionnement.

11. Procédé selon la revendication 9 ou 10, dans lequel la durée de la fenêtre temporelle est modifiée au bout d'une période de fonctionnement de la batterie (14).

12. Procédé selon l'une quelconque des revendications 1 à 11, comprenant en outre la détermination de l'état de santé de la batterie (14) et le maintien de l'état de charge de la batterie au premier état de charge maximale lorsque l'état de santé diminue en dessous d'une valeur d'état de santé.

13. Procédé selon l'une quelconque des revendications 1 à 12, dans lequel la charge de la batterie (14) est, en outre, interdite tant que la température de la batterie est supérieure à une cinquième valeur de température.

14. Procédé selon l'une quelconque des revendications 1 à 13, dans lequel la charge de la batterie (14) est, en outre, interdite tant que la température de la batterie est inférieure à une sixième valeur de température.

15. Système (10) comprenant un générateur électrique (16), une batterie (14), un circuit (18) de charge de la batterie à partir de l'énergie électrique fournie par le générateur et un module (20) de commande du circuit de charge, le module de commande étant adapté à commander la charge de la batterie à un premier état de charge maximale dans un premier mode de fonctionnement et à un deuxième état de charge maximale, strictement inférieur au premier état de charge maximale, dans un deuxième mode de fonctionnement, **caractérisé en ce que** le module de commande est adapté à passer du deuxième mode de fonctionnement au premier mode de fonctionnement lorsque le rapport entre une première donnée représentative de l'énergie disponible pouvant être fournie par le générateur électrique et une deuxième donnée représentative de l'énergie consommée depuis la batterie devient inférieur à un premier seuil.

16. Système selon la revendication 15, dans lequel le module (20) de commande est adapté à passer du premier mode de fonctionnement au deuxième mode de fonctionnement lorsque le rapport entre la première donnée représentative de l'énergie disponible pouvant être fournie par le générateur électrique et la deuxième donnée représentative de l'énergie consommée depuis la batterie devient supérieur au premier seuil ou à un deuxième seuil différent du premier seuil.

17. Système selon la revendication 15 ou 16, dans lequel le module de commande (20) est adapté à commander la charge de la batterie (14) à un troisième état de charge maximale strictement inférieur au deuxième état de charge maximale dans un troisième mode de fonctionnement et dans lequel le module de commande est adapté à passer du troisième mode de fonctionnement au deuxième mode de fonctionnement lorsque le rapport entre la première donnée et la deuxième donnée devient inférieur à un deuxième seuil supérieur strictement au premier seuil.

18. Système selon la revendication 17, dans lequel le module (20) de commande est adapté à passer du deuxième mode de fonctionnement au troisième mode de fonctionnement lorsque le rapport entre la première donnée et la deuxième donnée devient supérieur au troisième seuil, ou à un quatrième seuil différent du troisième seuil et supérieur strictement au premier seuil.

19. Système selon l'une quelconque des revendications 15 à 18, dans lequel le générateur électrique (16) comprend des cellules photovoltaïques.

**Patentansprüche**

1. Verfahren zum Laden einer Batterie (14) von elektrischen Akkumulatoren aus der von einem elektrischen Generator (16) gelieferten elektrischen Energie, wobei die Batterie in einem ersten Betriebsmodus auf einen ersten maximalen Ladezustand und in einem zweiten Betriebsmodus auf einen zweiten maximalen Ladezustand geladen wird, der niedriger als der erste maximale Ladezustand ist, **dadurch gekennzeichnet, dass** das Verfahren einen Übergang vom zweiten Betriebsmodus zum ersten Betriebsmodus aufweist, wenn das Verhältnis einer ersten Größe, die für die verfügbare Energie repräsentativ ist, die durch den elektrischen Generator geliefert werden kann, zu einer zweiten Größe, die für die aus der Batterie verbrauchte Energie repräsentativ ist, kleiner als ein erster Schwellenwert wird.

2. Verfahren nach Anspruch 1, aufweisend einen Übergang vom ersten Betriebsmodus zum zweiten Betriebsmodus, wenn das Verhältnis der ersten Größe, die für die verfügbare Energie repräsentativ ist, die durch den elektrischen Generator geliefert werden kann, zu der zweiten Größe, die für die aus der Batterie verbrauchte Energie repräsentativ ist, größer als der erste Schwellenwert oder als ein vom ersten Schwellenwert verschiedener zweiter Schwellenwert wird.

3. Verfahren nach Anspruch 1 oder 2, wobei die Batterie (14) in einem dritten Betriebsmodus auf einen dritten maximalen Ladezustand geladen wird, der niedriger als der zweite maximale Ladezustand ist, wobei das Verfahren einen Übergang vom dritten Betriebsmodus zum zweiten Betriebsmodus aufweist, wenn das Verhältnis der ersten Größe zu der zweiten Größe kleiner als ein dritter Schwellenwert wird, der größer als der erste Schwellenwert ist.

4. Verfahren nach Anspruch 3, aufweisend einen Übergang vom zweiten Betriebsmodus zum dritten Betriebsmodus, wenn das Verhältnis der ersten Größe zu der zweiten Größe größer als der dritte Schwellenwert oder als ein vom dritten Schwellenwert verschiedener vierter Schwellenwert wird, der größer als der erste Schwellenwert ist.

5. Verfahren nach Anspruch 3 oder 4, wobei der erste maximale Ladezustand von 95 % bis 100 % variiert, wobei der zweite maximale Ladezustand von 50 % bis 95 % variiert und wobei der dritte maximale Ladezustand von 20 % bis 50 % variiert.

6. Verfahren nach einem der Ansprüche 3 bis 5, wobei der erste Schwellenwert von 1 bis 3 variiert und wobei der dritte Schwellenwert von 3 bis 15 variiert.

7. Verfahren nach einem der Ansprüche 1 bis 6, wobei der elektrische Generator (16) Photovoltaikzellen aufweist.

8. Verfahren nach Anspruch 7, wobei die erste Größe auf der Grundlage der Messung der von den Photovoltaikzellen empfangenen allgemeiner Strahlung bestimmt wird.

9. Verfahren nach einem der Ansprüche 1 bis 8, aufweisend Bestimmen erster Werte über ein Zeitfenster, wobei das Bestimmen der ersten Größe Bestimmen des Mittelwerts der ersten Werte über das Zeitfenster aufweist, wobei das Verfahren ferner Bestimmen zweiter Werte aufweist, wobei das Bestimmen der zweiten Größe Bestimmen des Mittelwerts der zweiten Werte über das Zeitfenster aufweist.

10. Verfahren nach Anspruch 9, wobei die Dauer des Zeitfensters im ersten Betriebsmodus von der Dauer des Zeitfensters im zweiten Betriebsmodus verschieden ist.

11. Verfahren nach Anspruch 9 oder 10, wobei die Dauer des Zeitfensters am Ende einer Betriebsperiode der Batterie (14) modifiziert wird.

12. Verfahren nach einem der Ansprüche 1 bis 11, ferner aufweisend Bestimmen des Gesundheitszustands der Batterie (14) und Halten des Ladezustands der Batterie auf dem ersten maximalen Ladezustand, wenn der Gesundheitszustand unter einen Gesundheitszustandswert absinkt.

13. Verfahren nach einem der Ansprüche 1 bis 12, wobei das Laden der Batterie (14) ferner untersagt ist, solange die Temperatur der Batterie höher als ein fünfter Temperaturwert ist.

14. Verfahren nach einem der Ansprüche 1 bis 13, wobei das Laden der Batterie (14) ferner untersagt ist, solange die Temperatur der Batterie niedriger als ein sechster Temperaturwert ist.

**15.** System (10), aufweisend einen elektrischen Generator (16), eine Batterie (14), einen Ladekreis (18) zum Laden der Batterie aus der von dem Generator gelieferten elektrischen Energie und ein Steuermodul (20) des Ladekreises, wobei das Steuermodul eingerichtet zum Steuern des Ladens der Batterie auf einen ersten maximalen Ladezustand in einem ersten Betriebsmodus und auf einen zweiten maximalen Ladezustand in einem zweiten Betriebsmodus ist, der niedriger als der erste maximale Ladezustand ist, **dadurch gekennzeichnet, dass** das Steuermodul eingerichtet zum Übergang vom zweiten Betriebsmodus zum ersten Betriebsmodus ist, wenn das Verhältnis einer ersten Größe, die für die verfügbare Energie repräsentativ ist, die durch den elektrischen Generator geliefert werden kann, zu einer zweiten Größe, die für die aus der Batterie verbrauchte Energie repräsentativ ist, kleiner als ein erster Schwellenwert wird.

**16.** System nach Anspruch 15, wobei das Steuermodul (20) eingerichtet zum Übergang vom ersten Betriebsmodus zum zweiten Betriebsmodus ist, wenn das Verhältnis der ersten Größe, die für die verfügbare Energie repräsentativ ist, die durch den elektrischen Generator geliefert werden kann, zu der zweiten Größe, die für die aus der Batterie verbrauchte Energie repräsentativ ist, größer als der erste Schwellenwert oder als ein vom ersten Schwellenwert verschiedener zweiter Schwellenwert wird.

**17.** System nach Anspruch 15 oder 16, wobei das Steuermodul (20) eingerichtet zum Steuern des Ladens der Batterie (14) auf einen dritten maximalen Ladezustand in einem dritten Betriebsmodus ist, der niedriger als der zweite maximale Ladezustand ist, und wobei das Steuermodul eingerichtet zum Übergang vom dritten Betriebsmodus zum zweiten Betriebsmodus ist, wenn das Verhältnis der ersten Größe zu der zweiten Größe kleiner als ein zweiter Schwellenwert wird, der größer als der erste Schwellenwert ist.

**18.** System nach Anspruch 17, wobei das Steuermodul (20) eingerichtet zum Übergang vom zweiten Betriebsmodus zum dritten Betriebsmodus ist, wenn das Verhältnis der ersten Größe zu der zweiten Größe größer als der dritte Schwellenwert oder als ein vom dritten Schwellenwert verschiedener vierter Schwellenwert wird, der größer als der erste Schwellenwert ist.

**19.** System nach einem der Ansprüche 15 bis 18, wobei der elektrische Generator (16) Photovoltaikzellen aufweist.

## Claims

**1.** A method of charging a battery (14) of electric accumulators from the electric power supplied by an electric generator (16), wherein the battery is charged to a first maximum state of charge in a first operating mode and to a second maximum state of charge, lower than the first maximum state of charge, in a second operating mode, **characterized in that** the method comprises switching from the second operating mode to the first operating mode when the ratio of a first quantity representative of the available power capable of being supplied by the electric generator to a second quantity representative of the power consumed from the battery becomes lower than a first threshold.

**2.** The method of claim 1, comprising switching from the first operating mode to the second operating mode when the ratio of the first quantity representative of the available power capable of being supplied by the electric power generator to the second quantity representative of the power consumed from the battery becomes higher than the first threshold or than a second threshold different from the first threshold.

**3.** The method of claim 1 or 2, wherein the battery (14) is charged to a third maximum state of charge lower than the second maximum state of charge in a third operating mode, the method comprising switching from the third operating mode to the second operating mode when the ratio of the first quantity to the second quantity becomes lower than a third threshold higher than the first threshold.

**4.** The method of claim 3, comprising switching from the second operating mode to the third operating mode when the ratio of the first quantity to the second quantity becomes higher than the third threshold, or than a fourth threshold different from the third threshold and higher than the first threshold.

**5.** The method of claim 3 or 4, wherein the first maximum state of charge varies from 95% to 100%, wherein the second maximum state of charge varies from 50% to 95%, and wherein the third maximum state of charge varies from 20% to 50%.

**6.** The method of any of claims 3 to 5, wherein the first threshold varies from 1 to 3 and wherein the third threshold varies

from 3 to 15.

7. The method of any of claims 1 to 6, wherein the electric generator (16) comprises photovoltaic cells.

8. The method of claim 7, wherein the first quantity is determined based on the measurement of the general irradiance received by the photovoltaic cells.

9. The method of any of claims 1 to 8, comprising determining first values over a time window, the determination of the first quantity comprising determining the average of the first values over the time window, the method further comprising determining second values, the determination of the second quantity comprising determining the average of the second values over the time window.

10. The method of claim 9, wherein the duration of the time window in the first operating mode is different from the duration of the time window in the second operating mode.

11. The method of claim 9 or 10, wherein the duration of the time window is modified at the end of an operating period of the battery (14).

12. The method of any of claims 1 to 11, further comprising determining the state of health of the battery (14) and holding the state of charge of the battery in the first maximum state of charge when the state of health decreases below a state-of-health value.

13. The method of any of claims 1 to 12, wherein the charge of the battery (14) is further forbidden as long as the temperature of the battery is higher than a fifth temperature value.

14. The method of any of claims 1 to 13, wherein the charge of the battery (14) is further forbidden as long as the temperature of the battery is lower than a sixth temperature value.

15. A system (10) comprising an electric generator (16), a battery (14), a circuit (18) for charging the battery from the electric power supplied by the generator, and a charge circuit control unit (20), the control unit being capable of controlling the battery charge to a first maximum state of charge in a first operating mode and to a second maximum state of charge, lower than the first maximum state of charge, in a second operating mode, **characterized in that** the control unit is capable of switching from the second operating mode to the first operating mode when the ratio of a first quantity representative of the available power capable of being supplied by the electric generator to a second quantity representative of the power consumed from the battery becomes lower than a first threshold.

16. The system of claim 15, wherein the control unit (20) is capable of switching from the first operating mode to the second operating mode when the ratio of the first quantity representative of the available power capable of being supplied by the electric generator to the second quantity representative of the power consumed from the battery becomes higher than the first threshold or than a second threshold different from the first threshold.

17. The system of claim 15 or 16, wherein the control unit (20) is capable of controlling the charge of the battery (14) to a third maximum state of charge lower than the second maximum state of charge in a third operating mode, and wherein the control unit is capable of switching from the third operating mode to the second operating mode when the ratio of the first quantity to the second quantity becomes lower than a second threshold higher than the first threshold.

18. The system of claim 17, wherein the control unit (20) is capable of switching from the second operating mode to the third operating mode when the ratio of the first quantity to the second quantity becomes higher than the third threshold, or than a fourth threshold different from the third threshold and higher than the first threshold.

19. The system of any of claims 15 to 18, wherein the electric generator (16) comprises photovoltaic cells.

10
16
Générateur
24
Circuit de mesure
18
Circuit de charge
Module de Commande
20
22
Capteur de température
14
Batterie
Circuit de mesure
12
Système
26

Fig 1

30
O
$T_{min} < T < T_{max}$ ?
N
Charge autorisée
32
34
Charge interdite

Fig 2

Esol/Eutil
40
35
30
25
20
15
10
5
0
1
3
5
7
9
11
mois
C1
C2
C3

Fig 3

Initialisation
40
Détermination
Esol, Eutil
42
44
Esol/Eutil
> 10
Oui
46
Soc
30%
Non
48
Esol/Eutil
> 2
Oui
50
Soc
90%
Non
52
Soc
100%

Fig 4

Wh/j
CEsol
Esol/Eutil=10
temps (jours)
%
RSOC
CSOC
temps (jours)
heures
C40
temps (jours)
%
CSOH2
CSOH1
temps (jours)

Fig 5

Wh/j
CEsol
Esol/Eutil=10
temps (jours)
%
CSOC
RSOC
temps (jours)
heures
C40
temps (jours)
%
CSOH2
CSOH1
temps (jours)

Fig 6

Initialisation
40
60
SOH>60%
Non
Oui
Détermination
Esol, Eutil
42
44
Esol/Eutil
> 10
Oui
46
Soc
30%
Non
48
Esol/Eutil
> 2
Oui
50
Soc
90%
Non
52
Soc
100%
Détermination du SOH
62

Fig 7

CEsol
Seuil 10
Esol/Eutil=10
SoC 90%
RSOC
SoC 30%

Fig 8

Esol/Eutil
Seuil 15
Seuil 10
SoC 90%
SOC1
SoC 30%
SoC 90%
SOC2
SoC 30%

Fig 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- FR 2964265
- EP 1883143 A
- FR 3013151
- FR 3015124
- JP 2012075282 A
- CN 103904379
- US 2016013521 A
- US 2013049702 A
- US 2016332531 A
- EP 3190681 A


### Littérature non-brevet citée dans la description


- Electrochemical Energy Storage for Renewable Sources and Grid Balancing. **ANGEL KIRCHEV**. Battery management and battery diagnostics. Elsevier B.V, 2015, 411-435